# EUROPÄISCHE PATENTSCHRIFT

(11) **EP 0 443 072 B1**
(45) Veröffentlichungstag und Bekanntmachung des Hinweises auf die Patenterteilung: **12.01.1994**
(21) Anmeldenummer: 90103520.4
(22) Anmeldetag: 23.02.1990
(51) Int. Cl.: H05K 9/00

(54) **Abschirmgehäuse zur thermischen Behandlung von Rotoren**
Shielded case for the thermical treatment of rotors
Boîtier blindé pour le traitement thermique de rotors

(43) Veröffentlichungstag der Anmeldung: 28.08.1991
(73) Patentinhaber: CARL SCHENCK AG, D-64273 Darmstadt (DE)
(72) Erfinder: Thelen, Dieter, Dr., D-6101 Modautal 3 (DE)
(74) Vertreter: Brandt, Ernst-Ulrich, Dipl.-Phys., Dipl.-Ing.

(56) Entgegenhaltungen:
- EP-A- 0 073 421
- EP-A- 0 089 401
- DE-A- 2 945 144
- DE-A- 3 441 191
- US-A- 4 181 613

## Beschreibung

Die Erfindung betrifft ein Abschirmgehäuse zur thermischen Behandlung von Rotoren.

Rotoren von z. B. elektrischen Generatoren und anderen Maschinen müssen vor der Montage meist ausgewuchtet und einem Schnellauftest unterzogen werden. Aus Sicherheitsgründen sind die Rotoren hierbei meist in Schleuderbunkern angeordnet. Um eine vollständige Überprüfung der Rotoren auch bei den im Betrieb auftretenden Temperaturen durchzuführen, ist es erforderlich, die Rotoren auf die jeweils vorgeschriebene Temperatur zu erwärmen, diese Temperatur aber für den jeweiligen Prüfvorgang auch einzuhalten.

Bereits durch die bei der Drehung des Rotors auftretende Luftreibung als Ventilationsverlust tritt eine Erwärmung des Rotors auf. Eine zusätzliche, den typischen Betriebsbedingungen entsprechende Erwärmung kann durch elektrische Ströme erzielt werden, die durch die Wicklungen des Rotors geleitet werden. Zur Begrenzung des Temperaturanstiegs ist bereits erwogen worden, Luft aus der den Rotor aufnehmenden Kammer abzusaugen und im Kreislauf über eine Kühleinrichtung wieder zuzuführen. Der hierfür erforderliche Bauaufwand wäre aber verhältnismäßig hoch.

Da die im Rotor fließenden elektrischen Ströme ein mit dem Rotor umlaufendes Magnetfeld erzeugen, werden Wirbelströme in den in der Nähe befindlichen Metallteilen verursacht. Deshalb ist eine Abschirmung gegen diese rotierenden Magnetfelder erforderlich. Ein bekanntes Abschirmgehäuse der eingangs genannten Gattung (DE-OS 29 45 144) ist ausschließlich zur Abschirmung der rotierenden Magnetfelder bestimmt. Es besteht aus mehreren metallischen Segmenten, die in Anpassung an die jeweilige Rotorgröße zusammengefügt werden können. Eine Temperaturregelung für den Innenraum dieses Abschirmgehäuses ist hierbei nicht vorgesehen.

Bei einer anderen bekannten Abschirmeinrichtung zur magnetischen Abschirmung eines Rotors in einem Schleuderbunker (US-PS 4 489 218) ist anstelle eines Abschirmgehäuses ein metallischer Käfig vorgesehen, dessen Käfigstäbe von Kühlwasser durchflossen sind. Diese Kühlung dient aber nur dazu, die Wärme abzuführen, die durch die Wirbelströme erzeugt wurde, die von den umlaufenden Magnetfeldern in den Käfigstäben induziert wurden. Eine Regelung der Temperatur für den Rotor ist nicht vorgesehen.

Aufgabe der Erfindung ist es daher, ein Abschirmgehäuse der eingangs genannten Gattung so auszubilden, daß in konstruktiv einfacher Weise und mit geringem Betriebsaufwand eine Regelung der Rotortemperatur ermöglicht wird. Diese Aufgabe wird erfindungsgemäß dadurch gelöst, daß die Gehäusewände des Abschirmgehäuses wärmeisoliert ausgeführt sind, und daß die Gehäusewände mindestens eine Austauschöffnung aufweisen, deren Durchtrittsquerschnitt verstellbar ist.

Da die Gehäusewände wärmeisoliert sind, kann mittels der Klappensteuerung der Luftaustausch und damit der Wärmeaustausch zwischen dem Gehäuseinnenraum, der durch den Rotor erwärmt wird, und dem umgebenden Raum des Schleuderbunkers so gesteuert werden, daß sich im Gehäuseinnenraum die jeweils gewünschte Temperatur einstellt.

Es ist zwar bekannt, Maschinen mit einem Maschinengehäuse oder einer Haube zu verkleiden, in die ein Kühlluftkanal mit einem Kühlluftgebläse mündet, um der Maschine die erforderliche Kühlluft zuzuführen (DE-OS 23 30 016, DE-OS 28 17 411). Hierbei handelt es sich aber um die Kühlung von im Betrieb befindlichen Maschinen und nicht um die Temperatureinstellung von zu testenden Rotoren.

Gemäß einer bevorzugten Ausführungsform der Erfindung ist vorgesehen, daß in den Gehäusewänden mindestens eine Lufteintrittsöffnung und mindestens eine Luftaustrittsöffnung ausgespart sind, deren Durchtrittsquerschnitt jeweils durch eine steuerbare Luftklappe veränderbar ist. Dadurch wird in besonders wirksamer Weise ein Luftaustausch und damit ein Wärmeaustausch zwischen dem Gehäuseinnenraum und dem umgebenden Raum des Schleuderbunkers ermöglicht. Der Lufttransport erfolgt hierbei ausschließlich durch den vom drehenden Rotor im Gehäuseinnenraum erzeugten Luftwirbel, so daß auf ein aufwendiges Gebläse verzichtet werden kann.

Dieser Lufttransport durch den sich drehenden Rotor wird gemäß einer weiteren Ausgestaltung des Erfindungsgedankens noch besonders dadurch unterstützt, daß die Lufteinlaßöffnung mit ihrer Luftklappe einen angenähert tangential zum Rotor in das Abschirmgehäuse einmündenden Strömungskanal bildet und daß die Luftaustrittsöffnung einen angenähert tangential zum Rotor aus dem Ausgleichsgehäuse herausführenden Strömungskanal bildet.

Weitere vorteilhafte Ausgestaltungen des Erfindungsgedankens sind Gegenstand weiterer Unteransprüche.

Nachfolgend wird ein Ausführungsbeispiel der Erfindung näher erläutert, das in der Zeichnung dargestellt ist. Es zeigt:
- Fig. 1:: einen vereinfachten senkrechten Schnitt durch einen Schleuderbunker, in dem ein Abschirmgehäuse zur Aufnahme eines Rotors eines elektrischen Generators angeordnet ist,
- Fig. 2:: das Abschirmgehäuse nach Fig. 1 in einer Stellung für Rotoren mit kleinerem Durchmesser und
- Fig. 3:: einen vergrößerten Teilausschnitt durch eine Gehäusewand des Abschirmgehäuses.

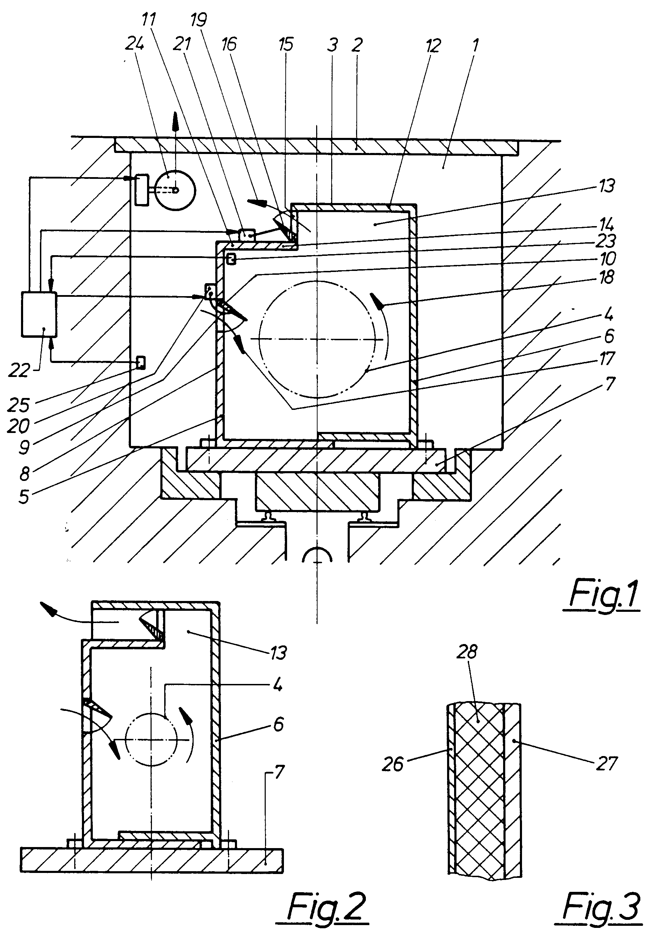

Der in Fig. 1 gezeigte Schleuderbunker besteht aus einer Grube 1, die durch einen abnehmbaren Betondeckel 2 verschlossen ist. In einer anderen üblichen Bauart kann der Schleuderbunker auch als stirnseitig zugänglicher Tunnel ausgeführt sein.

Im Schleuderbunker ist ein Abschirmgehäuse 3 zur Aufnahme eines mit strichpunktierten Linien nur angedeuteten Rotors 4 angeordnet. Der Rotor 4 ist der Läufer eines elektrischen Generators. Der Rotor 4 soll mittels einer (nicht dargestellten) Antriebs- und Lagereinrichtung vor der Montage des Generators ausgewuchtet und einem Schnellauftest unterzogen werden.

Das Abschirmgehäuse 3 besteht aus zwei querverschiebbaren Gehäusehälften 5 und 6, die schachtelartig ineinandergreifen. Die beiden Gehäusehälften 5 und 6 können je nach dem Durchmesser des aufzunehmenden Rotors 4 in unterschiedlichen Positionen auf einem Unterboden 7 festgeschraubt werden, der auch die (nicht dargestellten) Lagerungen für den Rotor 4 trägt.

Die Position der beiden Gehäusehälften 5 und 6 wird zweckmäßigerweise jeweils so gewählt, daß der horizontale Abstand zum Rotor 4 immer etwa 0,5 m beträgt. Fig. 1 zeigt die Anordnung der Gehäusehälften 5 und 6 bei einem Rotor 4 mit größerem Durchmesser, während in Fig. 2 die Position der Gehäusehälften 5 und 6 bei der Aufnahme eines Rotors 4 mit kleinerem Durchmesser dargestellt ist. Die Gehäusehälften 5 und 6 sind hierbei schachtelartig ineinandergeschoben.

In der einen seitlichen Gehäusewand 8 ist etwa in Höhe der Achse des Rotors 4 eine Austauschöffnung für das Wärmeaustauschmedium als Lufteintrittsöffnung 9 ausgespart, die mittels einer am oberen Öffnungsrand angelenkten Luftklappe 10 in ihrem Durchtrittsquerschnitt verändert bzw. geöffnet werden und geschlossen werden kann.

Die obere Gehäusewand 11 der einen Gehäusehälfte 5 ist niedriger angeordnet als die obere Gehäusewand 12 der anderen Gehäusehälfte 6, so daß ein in den Innenraum 13 des Abschirmgehäuses 3 vorspringender Absatz 14 entsteht, in dem eine weitere Austauschöffnung als Luftaustrittsöffnung 15 angeordnet ist. Auch diese Luftaustrittsöffnung 15 kann mittels einer Luftklappe 16 geöffnet und verschlossen werden bzw. der Durchtrittsquerschnitt der Luftaustrittsöffnung 15 kann mittels der Luftklappe 16 verändert werden.

Die Lufteintrittsöffnung 9 bildet zusammen mit ihrer ganz oder teilweise geöffneten Luftklappe 10 einen durch einen Pfeil 17 angedeuteten, angenähert tangential zum Rotor 4 verlaufenden Strömungskanal, durch den Luft aus der Grube 1 in den Gehäuseinnenraum 13 eingesaugt wird, wenn sich der Rotor 4 in der durch den Pfeil 18 angedeuteten Richtung (entgegengesetzt zum Uhrzeigersinn in Fig. 1) dreht.

Durch die Anordnung der Luftaustrittsöffnung 15 an dem in den Gehäuseinnenraum 13 ragenden Vorsprung 14 wird dort ein durch einen Pfeil 19 angedeuteter Strömungskanal gebildet, der angenähert tangential zum Rotor 4 aus dem Gehäuseinnenraum 13 herausführt. Bei der Drehung des Rotors 4 in Richtung des Pfeiles 18 und bei ganz oder teilweise geöffneten Luftklappen 10, 16 erzeugt die Rotordrehung somit einen Luftkreislauf zwischen der Grube 1 und dem Gehäuseinnenraum 13.

Beide Luftklappen 10, 16 sind jeweils mit einem Klappenantrieb 20 bzw. 21 verbunden, die durch eine Klappensteuerung 22 gesteuert werden. Die Klappensteuerung 22 bildet mit einem Temperaturfühler 23 einen geschlossenen Regelkreis, der die Temperatur im Gehäuseinnenraum 13 regelt. Die Klappensteuerung 22 hält die Luftklappen 10, 16 geschlossen, bis durch die Ventilationsverluste des sich drehenden Rotors 4 und/oder einen durch die Wicklungen des Rotors 4 geleiteten Strom eine Erwärmung des Gehäuseinnenraums 13 auf die jeweils gewünschte Temperatur erreicht wurde. Dann öffnet die Klappensteuerung 22 die Luftklappen 10, 16, so daß es zu einem Luft- und Wärmeaustausch mit dem umgebenden Raum in der Grube 1 kommt. Zum Wärmeaustausch sind auch andere gasförmige Stoffe als Wärmeaustauschmedium einsetzbar. So ist insbesondere bei höheren Temperaturen Kohlendioxid aus Brandgefährdungsgesichtspunkten als Wärmeaustauschmedium vorteilhaft.

Zur Vermeidung eines unzulässigen Temperaturanstieges im Innenraum der Grube 1 kann ein in Fig. 1 nur vereinfacht angedeutetes Gebläse 24 eingeschaltet werden, das eine Kühlung bzw. einen Luftaustasuch zwischen der Grube 1 und der Umgebung herbeiführt. Hierfür kann in der Grube 1 ein Temperaturfühler 25 angeordnet sein, der beim Erreichen einer vorgegebenen Temperatur einen Steuerbefehl an die Steuerung 22 gibt.

Um einen unkontrollierten Wärmeaustausch zwischen dem Gehäuseinnenraum 13 und der Umgebung in der Grube 1 zu verhindern, sind die Gehäusewände des Abschirmgehäuses 3 wärmeisoliert ausgeführt. Fig. 3 zeigt einen Teilschnitt durch eine Gehäusewand. Bei dem dargestellten Ausführungsbeispiel sind zwischen einer äußeren Wandschalung 26 aus dünnerem Aluminiumblech und einer inneren Wandschalung 27 aus dickerem Aluminiumblech eine Wärmeisolierschicht 28 angeordnet. Eine solche Wärmeisolierschicht kann sowohl aus handelsüblichen Isoliermaterialien, als auch aus einer Luftschicht bestehen. Die innere Wandverschalung 27 besteht aus Aluminiumblech von beispielsweise 10 mm Dicke, das eine magnetische Abschirmverkleidung bildet, die die vom Rotor 4 erzeugten rotierenden Magnetfelder nach außen nach Art eines Faradayschen Käfigs abschirmt. Die Wandschalung 27 wird nur dann aus Aluminiumblech gefertigt, wenn durch die magnetische Abschirmung die Aufheizung durch Wirbelstromverluste gering gehalten werden soll. Andernfalls sind auch Wandschalungen aus Stahlblech einsetzbar. An den Verbindungsstellen der einzelnen Gehäuseteile bzw. Gehäusesegmente erfolgt die Verbindung aneinanderstoßender innerer Wandverschalungen 27 so, daß eine ausreichende elektrische Leitfähigkeit gewährleistet ist, damit die auftretenden induzierten Ströme unbehindert fließen können.

Die Luftklappe 10, die sich nach innen öffnet und sich deshalb dem Rotor 4 besonders annähert, wird vorzugsweise aus magnetisch und elektrisch nichtleitendem Material hergestellt, beispielsweise Kunststoffmaterial.

Um die Wirkung der magnetischen Kräfte zwischen dem Rotor 4 und dem Gehäuse 3 symmetrisch zu halten, können die Öffnungen 9 und 15 in magnetischer und elektrischer Hinsicht symmetrisch ausgeführt werden. Dadurch wird eine resultierende Querkraft auf den Rotor 4 vermieden und dieser nicht zu Biegeschwingungen angeregt.

Arbeiten am stillstehenden Rotor 4 können bei geöffneter Luftklappe 10 durch die Lufteintrittsöffnung 9 hindurch ausgeführt werden. Dabei ist es nicht erforderlich, daß das Bedienungspersonal den aufgeheizten Gehäuseinnenraum 13 betritt.

Fig. 2 zeigt, daß die beiden Gehäusehälften 5 und 6 gegeneinandner verschoben werden können, wenn ein Rotor 4 mit kleinerem Durchmesser aufgenommen werden soll. Dadurch wird die Größe des Gehäuseinnenraums 13 an die jeweilige Rotorgröße angepaßt.

Das erfindungsgemäße Abschirmgehäuse ist nicht nur für Rotoren elektrischer Maschinen einsetzbar, sondern für alle Arten von Rotoren, die unter bestimmten thermischen Verhältnissen geprüft oder ausgewuchtet werden sollen. Dabei ist dieses Abschirmgehäuse sowohl in einem Schleuderbunker als auch in anderen Schutzbauten oder außerhalb davon einsetzbar.

## Patentansprüche

1. Abschirmgehäuse zur thermischen Behandlung von Rotoren, dadurch gekennzeichnet, daß die Gehäusewände des Abschirmgehäuses (3) wärmeisoliert ausgeführt sind und daß die Gehäusewände mindestens eine Austauschöffnung für das Wärmeaustauschmedium (9 bzw. 15) aufweist, dessen Durchtrittsquerschnitt verstellbar ist.

2. Abschirmgehäuse nach Anspruch 1, dadurch gekennzeichnet, daß die Austauschöffnung eine Luftaustauschöffnung darstellt, deren Durchtrittsquerschnitt mittels einer durch eine Klappensteuerung verstellbaren Luftklappe (10 bzw. 16) veränderbar ist, und daß die Klappensteuerung (22) mit einem im Innenraum (13) des Abschirmgehäuses (3) angeordneten Temperaturfühlers (23) über Regelglieder verbunden ist.

3. Abschirmgehäuse nach Anspruch 1 oder 2, dadurch gekennzeichnet, daß in den Gehäusewänden mindestens eine Lufteintrittsöffnung (9) und mindestens eine Luftaustrittsöffnung (15) ausgespart sind, deren Durchtrittsquerschnitt jeweils durch eine steuerbare Luftklappe (10 bzw. 16) veränderbar ist.

4. Abschirmgehäuse nach Anspruch 3, dadurch gekennzeichnet, daß die Lufteinlaßöffnung (9) mit ihrer Luftklappe (10) einen angenähert tangential zum Rotor (4) in das Abschirmgehäuse (3) einmündenden Strömungskanal (17) bildet.

5. Abschirmgehäuse nach Anspruch 3, dadurch gekennzeichnet, daß die Luftaustrittsöffnung (15) einen angenähert tangential zum Rotor (4) aus dem Abschirmgehäuse (3) herausführenden Strömungskanal (19) bildet.

6. Abschirmgehäuse nach Anspruch 5, dadurch gekennzeichnet, daß die Luftaustrittsöffnung (15) an einem in den Innenraum (13) des Abschirmgehäuses (3) vorspringenden Absatz (14) ausgebildet ist.

7. Abschirmgehäuse nach Anspruch 1, dadurch gekennzeichnet, daß es aus zwei gegeneinander verschiebbaren, schachtelartig ineinandergreifenden Gehäusehälften (5, 6) gebildet ist.

8. Abschirmgehäuse nach Anspruch 1, dadurch gekennzeichnet, daß die Gehäusewände eine Wärmeisolationsschicht (28) und mindestens eine aus Metallblech bestehende magnetische Abschirmverkleidung (27) aufweisen.

9. Abschirmgehäuse nach Ansprüchen 7 oder 8, dadurch gekennzeichnet, daß die obere Gehäusewand (11) der einen Gehäusehälfte (5) niedriger als die obere Gehäusewand (12) der anderen Gehäusehälfte (6) liegt und daß zwischen diesen beiden oberen Gehäusewänden (11, 12) die Luftaustrittsöffnung (15) gebildet ist.

## Claims

1. Screening case for the thermal treatment of rotors, characterised in that the case walls of the screening case (3) are constructed thermally insulated and that the case walls comprise at least one exchange opening for the heat exchange medium (9 or 15), whose cross-sectional area of passage is adjustable.

2. Screening case according to claim 1, characterised in that the exchange opening represents an air exchange opening whose cross-sectional area of passage is variable by means of an air shutter (10 or 16) adjustable by a valve controller, and that the valve controller (22) is connectable via control elements to a temperature probe (23) arranged in the interior (13) of the screening case (3).

3. Screening case according to claim 1 or 2, characterised in that in the case walls at least one air inlet opening (9) and at least one air outlet opening (15) are cut out, whose cross-sectional area of passage is variable in each case by a controllable air shutter (10 or 16).

4. Screening case according to claim 3, characterised in that the air inlet opening (9) forms with its air shutter (10) a flow channel (17) issuing into the screening case (3) approximately tangentially to the rotor (4).

5. Screening case according to claim 3, characterised in that the air outlet opening (15) forms a flow channel (19) leading out of the screening case (3) approximately tangentially to the rotor (4).

6. Screening case according to claim 5, characterised in that the air outlet opening (15) is formed on a shoulder (14) projecting into the interior (13) of the screening case (3).

7. Screening case according to claim 1, characterised in that it is formed of two case halves (5, 6) movable against one another and interlocking with one another after the manner of a box.

8. Screening case according to claim 1, characterised in that the case walls comprise a thermally insulating layer (28) and at least one magnetic screening covering (27) consisting of sheet metal.

9. Screening case according to claims 7 or 8, characterised in that the upper case wall (11) of the one case half (5) lies lower than the upper case wall (12) of the other case half (6) and that between said two upper case walls (11, 12) the air outlet opening (15) is formed.

## Revendications

1. Caisson blindé pour le traitement thermique de rotors, caractérisé en ce que les parois du caisson blindé (3) sont isolées thermiquement et en ce que les parois de caisson présentent au moins une ouverture d'échange calorifique, destinée au fluide d'échange calorifique (9 ou 15), dont la section transversale de passage est réglable.

2. Caisson blindé selon la revendication 1, caractérisé en ce que l'ouverture d'échange constitue une ouverture d'échange par air, dont la section transversale de passage est modifiable au moyen d'un volet d'air (10 ou 16), réglable au moyen d'une commande de volet, et en ce que la commande de volet (22) est reliée, par l'intermédiaire d'organes de régulation, à une sonde de température (23), disposée dans l'espace intérieur (13) du caisson blindé (3).

3. Caisson blindé selon la revendication 1 ou 2, caractérisé en ce que, dans les parois de caisson, sont ménagées au moins une ouverture d'entrée d'air (9) et au moins une ouverture de sortie d'air (15), dont la section transversale de passage est chaque fois modifiable au moyen d'un volet d'air (10 ou 16) pouvant être placé sous l'action d'une commande.

4. Caisson blindé selon la revendication 3 caractérisé en ce que l'ouverture d'entrée d'air (9) forme avec son volet d'air (10) un canal d'écoulement (17) entrant dans le caisson blindé (3) à peu près tangentiellement par rapport au rotor (4).

5. Caisson blindé selon la revendication 3 caractérisé en ce que l'ouverture de sortie d'air (15) forme un canal d'écoulement (19), sortant du caisson blindé (3) à un peu près tangentiellement par rapport au rotor (4).

6. Caisson blindé selon la revendication 5 caractérisé en ce que l'ouverture de sortie d'air (15) est réalisée sur un décrochement (14), se projetant dans l'espace intérieur (13) du caisson blindé (3).

7. Caisson blindé selon la revendication 1 caractérisé en ce qu'il est formé de deux demi-caissons (5,6) déplaçables l'un par rapport à l'autre et s'engageant l'un dans l'autre à la façon d'une boîte.

8. Caisson blindé selon la revendication 1 caractérisé en ce que les parois de caisson présentent une couche d'isolation thermique (28) et au moins un revêtement de blindage magnétique (27) réalisé en tôle.

9. Caisson blindé selon la revendication 7 et 8 caractérisé en ce que la paroi de caisson supérieur (11) du demi-caisson (5) est plus basse que la paroi de caisson supérieure (12) de l'autre demi-caisson (6) et que l'ouverture de sortie d'air (15) est formée entre ces deux parois de caisson supérieur (11,12).
